# EUROPEAN PATENT APPLICATION

(11) **EP 3 531 014 A1**
(43) Date of publication of application: **28.08.2019**
(21) Application number: 18184623.9
(22) Date of filing: 20.07.2018
(51) Int. Cl.: F21S 45/50

(54) **VEHICLE LUMINAIRE, VEHICLE LAMP, AND METHOD FOR MANUFACTURING VEHICLE LUMINAIRE**

(30) Priority: 27.02.2018 JP 2018033110
(71) Applicant: Toshiba Lighting & Technology Corporation, Yokosuka-shi, Kanagawa 237-8510 (JP)
(72) Inventor: Hino, Kiyokazu, Kanagawa 237-8510 (JP); Ueno, Misaki, Kanagawa 237-8510 (JP)
(74) Representative: AWA Sweden AB

(57) **Abstract**

A vehicle luminaire (1) according to an exemplary embodiment includes: a socket (10); a board (21) provided at one end side of the socket (10); at least one light-emitting element (22) provided on the board (21); a frame (25) provided on the board (21), having a tube shape, and surrounding the light-emitting element (22); a sealing part (26) provided inside the frame (25) and covering the light-emitting element (22); and an optical element (27) provided on the sealing part (26), at least a part of a circumferential edge being provided at an end face (25a) of the frame (25) opposite to the board (21) side.

## Description

### FIELD

Exemplary embodiments described herein relate to a vehicle luminaire, a vehicle lamp, and a method for manufacturing a vehicle luminaire.

### BACKGROUND

A vehicle luminaire including a socket and a light-emitting module provided at one end side of the socket is known. The light-emitting module includes a board, a light-emitting diode (LED) provided on the board, a frame surrounding the light-emitting diode, and a sealing part provided inside the frame and covering the light-emitting diode.

The sealing part is generally formed by filling the inside of the frame with a resin with translucency. In this case, if the surface of the sealing part opposite to the board side is a flat surface, light extracting efficiency may decrease.

In this regard, a technology of forming the surface of a sealing part opposite to a board side into a curved surface is suggested. However, if the curved surface is simply formed by a resin supplied to the inside of a frame, the shape of the curved surface may vary so that predetermined light distribution characteristics may not be obtainable.

For this reason, a technology of forming a lens using a mold and bonding the lens onto a sealing part that is the inside of a frame is suggested. However, if the lens is provided inside the frame, a gap needs to be provided between an inner wall of the frame and a circumferential edge of the lens. Therefore, a position of the lens may vary so that predetermined light distribution characteristics may not be obtainable. In addition, the resin for forming the sealing part may leak from the gap between the inner wall of the frame and the circumferential edge of the lens. When the leaked resin is attached to the circumferential edge of the lens, the shape of a light-emitting surface of the lens may substantially change so that predetermined light distribution characteristics may not be obtainable.

In this regard, there is a demand for development of a technology capable of obtaining predetermined light distribution characteristics.

### BRIEF DESCRIPTION OF THE DRAWINGS

FIG. 1 is a schematic perspective view for illustrating a vehicle luminaire according to an exemplary embodiment;
FIG. 2 is a cross-sectional view taken along line A-A in FIG. 1;
FIG. 3 is a schematic cross-sectional view for illustrating an optical element according to a comparative example;
FIG. 4 is a schematic cross-sectional view for illustrating an optical element according to an exemplary embodiment;
FIGS. 5A and 5B are schematic cross-sectional views for illustrating an optical element according to another exemplary embodiment;
FIGS. 6A and 6B are schematic cross-sectional views for illustrating an optical element according to another exemplary embodiment;
FIGS. 7A to 7C are schematic cross-sectional views for illustrating an optical element according to another exemplary embodiment;
FIG. 8 is a schematic perspective view for illustrating a frame according to another exemplary embodiment; and
FIG. 9 is a schematic partial cross-sectional view for illustrating a vehicle lamp.

### DETAILED DESCRIPTION

A vehicle luminaire according to an exemplary embodiment includes: a socket; a board provided at one end side of the socket; at least one light-emitting element provided on the board; a frame provided on the board, having a tube shape, and surrounding the light-emitting element; a sealing part provided inside the frame and covering the light-emitting element; and an optical element provided on the sealing part, at least a part of a circumferential edge being provided at an end face of the frame opposite to the board side.

Hereinafter, exemplary embodiments will be described with reference to the drawings. Note that identical constituent elements are given the same reference numerals throughout the drawings, and detailed description thereof will be omitted as appropriate.

### (Vehicle Luminaire)

A vehicle luminaire 1 according to an exemplary embodiment can be provided, for example, in an automobile, a rail vehicle, and the like. As the vehicle luminaire 1 provided in an automobile, for example, those used in a front combination light (for example, one obtained by appropriately combining a daylight running lamp (DRL), a position lamp, a turn signal lamp, and the like), a rear combination light (for example, one obtained by appropriately combining a stop lamp, a tail lamp, a turn signal lamp, a back lamp, a fog lamp, and the like), and the like can be exemplified. However, the application of the vehicle luminaire 1 is not limited thereto.

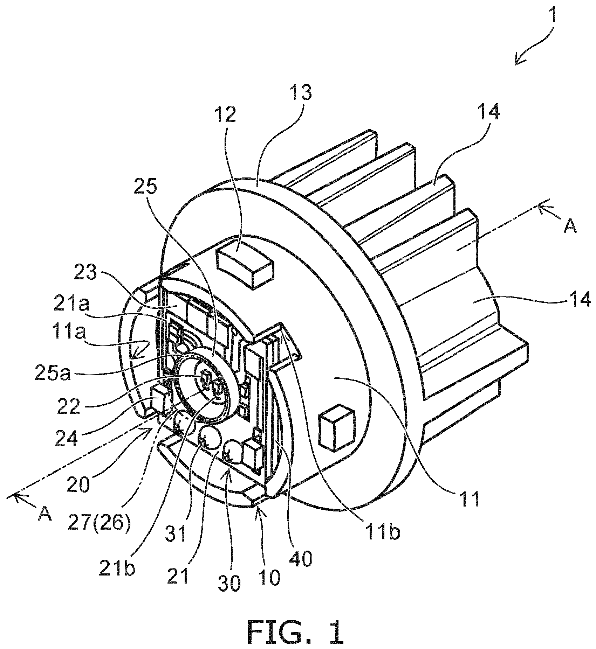

FIG. 1 is a schematic perspective view for illustrating the vehicle luminaire 1 according to the exemplary embodiment.

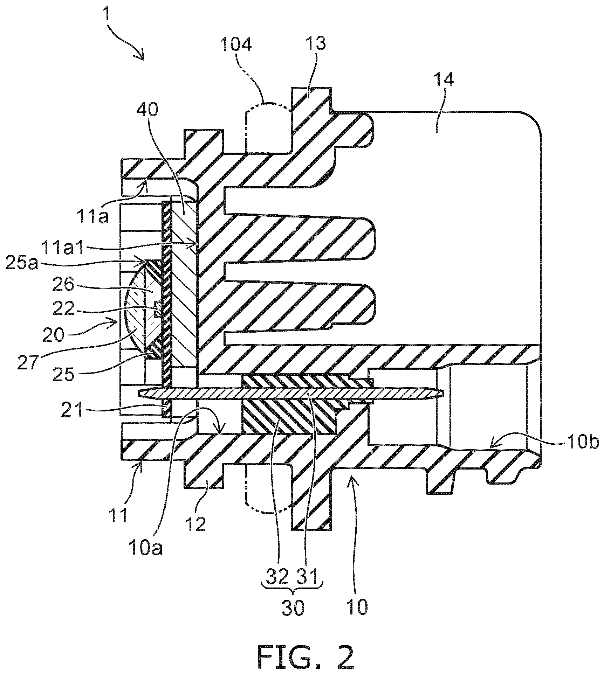

FIG. 2 is a cross-sectional view of the vehicle luminaire 1 taken along line A-A in FIG. 1.

As illustrated in FIGS. 1 and 2, the vehicle luminaire 1 includes a socket 10, a light-emitting module 20, a power-supply part 30, and a heat transfer part 40.

The socket 10 has a mounting part 11, a bayonet 12, a flange 13, and a thermal radiation fin 14.

The mounting part 11 is provided on the surface of the flange 13 opposite to the side at which the thermal radiation fin 14 is provided. The outer shape of the mounting part 11 can be a column shape. The outer shape of the mounting part 11 is, for example, a cylindrical shape. The mounting part 11 has a concave part 11a opened to an end face opposite to the flange 13 side. A light-emitting module 20 is provided at a bottom face 11a1 of the concave part 11a.

At least one slit 11b can be provided in the mounting part 11. A corner part of the board 21 is provided inside the slit 11b. The dimension (width dimension) of the slit 11b in a circumferential direction of the mounting part 11 is slightly larger than the dimension of the corner part of the board 21. Therefore, positioning of the board 21 can be performed by inserting the corner part of the board 21 to the inside of the slit 11b.

Further, if the slit 11b is provided, the planar shape of the board 21 can be increased. Therefore, the number of elements mounted on the board 21 can be increased. Alternatively, since the outside dimension of the mounting part 11 can be decreased, the mounting part 11 can be miniaturized, and further the vehicle luminaire 1 can be miniaturized.

The bayonet 12 is provided at an outer side surface of the mounting part 11. The bayonet 12 projects toward the outside of the vehicle luminaire 1. The bayonet 12 faces the flange 13. The bayonet 12 is provided in plural. The bayonet 12 is used when the vehicle luminaire 1 is mounted in a housing 101 of a vehicle lamp 100. The bayonet 12 is used for twist lock.

The flange 13 has a plate shape. The flange 13 can be formed, for example, in a disk shape. An outer side surface of the flange 13 is positioned at the outer side of the vehicle luminaire 1 than an outer side surface of the bayonet 12.

The thermal radiation fin 14 is provided at the side of the flange 13 opposite to the mounting part 11 side. At least one thermal radiation fin 14 can be provided. A plurality of thermal radiation fins are provided in the socket 10 illustrated in FIGS. 1 and 2. The plurality of thermal radiation fins 14 can be provided side by side in a predetermined direction. The thermal radiation fin 14 can be formed in a plate shape.

Further, a hole 10b into which a connector 105 is inserted is proved in the socket 10.

The connector 105 having a sealing member 105a is inserted into the hole 10b. For this reason, the cross-sectional shape of the hole 10b is a shape compatible with the cross-sectional shape of the connector 105 having the sealing member 105a.

Heat generated in the light-emitting module 20 is mainly transferred to the thermal radiation fin 14 through the mounting part 11 and the flange 13. The heat transferred to the thermal radiation fin 14 is mainly discharged from the thermal radiation fin 14 to the outside.

Therefore, the socket 10 is preferably formed by a material having a high rate of heat conductivity. For example, the socket 10 can be formed by a metal such as an aluminum alloy.

Further, in recent years, the socket 10 can efficiently radiate the heat generated in the light-emitting module 20 and is desirably lightweight.

For this reason, the mounting part 11, the bayonet 12, the flange 13, and the thermal radiation fin 14 are preferably formed by a resin with high heat conductivity. The resin with high heat conductivity includes, for example, a filler formed by a resin and an inorganic material. The resin with high heat conductivity is, for example, a resin obtained by mixing a filler formed by carbon or aluminum oxide with a resin such as polyethylene terephthalate (PET) or nylon.

Further, the mounting part 11, the bayonet 12, the flange 13, and the thermal radiation fin 14 can be integrally molded with the power-supply part 30 using an insert molding method or the like.

The heat generated in the light-emitting module 20 can be efficiently radiated using the socket 10 which contains a resin with high heat conductivity and in which the mounting part 11, the bayonet 12, the flange 13, and the thermal radiation fin 14 are integrally molded. Further, the weight of the socket 10 can be decreased.

The power-supply part 30 has a power-supply terminal 31 and an insulating part 32.

The power-supply terminal 31 can be formed in a rod-shape body. The power-supply terminal 31 projects from the bottom face 11a1 of the concave part 11a. The power-supply terminal 31 is provided in plural. The plurality of power-supply terminals 31 can be provided side by side in a predetermined direction. The plurality of power-supply terminals 31 are provided inside the insulating part 32. The insulating part 32 is provided between the power-supply terminal 31 and the socket 10. The plurality of power-supply terminals 31 extend in the inside of the insulating part 32 and project from an end face of the insulating part 32 at the light-emitting module 20 side and an end face of the insulating part 32 at the thermal radiation fin 14 side. Ends of the plurality of power-supply terminals 31 at the light-emitting module 20 side are electrically and mechanically connected to a wiring pattern 21a provided on the board 21. That is, one end of the power-supply terminal 31 is soldered with the wiring pattern 21a. The ends of the plurality of power-supply terminals 31 at the thermal radiation fin 14 side are exposed to the inside of the hole 10b. The connector 105 is fitted to the plurality of power-supply terminals 31 exposed to the inside of the hole 10b. The power-supply terminal 31 has electrical conductivity. The power-supply terminal 31 can be formed, for example, by a metal such as a copper alloy. Note that the numbers, shapes, arrangement, materials, and the like of the power-supply terminals 31 are not limited to the example, and can be changed as appropriate.

As described above, the socket 10 is preferably formed by a material having a high rate of heat conductivity. However, the material having a high rate of heat conductivity has electrical conductivity in some cases. For example, a resin with high heat conductivity containing a metal such as an aluminum alloy or a filler formed by carbon has electrical conductivity. Therefore, the insulating part 32 is provided to insulate between the power-supply terminal 31 and the socket 10 having electrical conductivity. In addition, the insulating part 32 also has a function of holding the plurality of power-supply terminals 31. Note that if the socket 10 is formed by an insulating resin with high heat conductivity (for example, a resin with high heat conductivity containing a filler formed by aluminum oxide, or the like), the insulating part 32 may not be provided. In this case, the socket 10 holds the plurality of power-supply terminals 31.

The insulating part 32 has insulation property. The insulating part 32 can be formed by a resin with insulation property.

Herein, in the case of the vehicle luminaire 1 provided in an automobile, a temperature in usage environment is -40°C to 85°C. Therefore, a coefficient of thermal expansion of the material of the insulating part 32 is preferably set to be close to a coefficient of thermal expansion of the material of the socket 10 as much as possible. In this way, thermal stress generated between the insulating part 32 and the socket 10 can be reduced. For example, the material of the insulating part 32 can be a resin with high heat conductivity contained in the socket 10 or a resin included in the resin with high heat conductivity.

The insulating part 32 can be, for example, press-inserted into a hole 10a provided in the socket 10 or attached to the inner wall of the hole 10a. In addition, the socket 10 and the power-supply part 30 can also be integrally molded by an insert molding method.

The heat transfer part 40 is provided between the board 21 and the bottom face 11a1 of the concave part 11a. The heat transfer part 40 is provided at the bottom face 11a1 of the concave part 11a through an attachment part. That is, the heat transfer part 40 is attached to the bottom face 11a1 of the concave part 11a.

An adhesive for attaching the heat transfer part 40 and the bottom face 11a1 of the concave part 11a is preferably an adhesive having a high rate of heat conductivity. For example, the adhesive can be an adhesive mixed with a filler using an inorganic material. The inorganic material is preferably a material having a high rate of heat conductivity (for example, ceramics such as aluminum oxide or aluminum nitride). A rate of heat conductivity of the adhesive can be set to, for example, 0.5 W/(m·K) or more and 10 W/(m·K) or less.

Further, the heat transfer part 40 can also be embedded in the bottom face 11a1 of the concave part 11a by an insert molding method. In addition, the heat transfer part 40 can also be attached to the bottom face 11a1 of the concave part 11a through a layer formed by heat conductive grease (thermal radiation grease). The type of heat conductive grease is not particularly limited, and for example, heat conductive grease obtained by mixing a filler using a material having a high rate of heat conductivity (for example, ceramics such as aluminum oxide or aluminum nitride) with modified silicone can be used. A rate of heat conductivity of the heat conductive grease can be set to, for example, 1 W/(m·K) or more and 5 W/(m·K) or less.

The heat transfer part 40 is provided to facilitate transferring of the heat generated in the light-emitting module 20 to the socket 10. For this reason, the heat transfer part 40 is preferably formed by a material having a high rate of heat conductivity. The heat transfer part 40 has a plate shape and can be formed, for example, by a metal such as aluminum, an aluminum alloy, copper, or a copper alloy.

The light-emitting module 20 has the board 21, a light-emitting element 22, a resistor 23, a control element 24, a frame 25, a sealing part 26, and an optical element 27.

The board 21 is provided at one end side of the socket 10. The board 21 is provided at the heat transfer part 40 through an attachment part. That is, the board 21 is attached to the heat transfer part 40. An adhesive can be, for example, the same as the adhesive for attaching the heat transfer part 40 and the bottom face 11a1 of the concave part 11a.

The board 21 has a plate shape. The planar shape of the board 21 can be, for example, a square shape. A material or a structure of the board 21 is not particularly limited. For example, the board 21 can be formed by an inorganic material such as ceramics (for example, aluminum oxide, aluminum nitride, or the like), an organic material such as paper phenol or glass epoxy, or the like. In addition, the board 21 may employ a board obtained by coating a surface of a metal plate with an insulating material. Note that if the surface of the metal plate is coated with the insulating material, the insulating material may be formed by an organic material or an inorganic material. If the amount of heat generated in the light-emitting element 22 is large, the board 21 is preferably formed using a material having a high rate of heat conductivity from the viewpoint of thermal radiation. As a material having a high rate of heat conductivity, for example, ceramics such as aluminum oxide or aluminum nitride, a resin with high heat conductivity, a material obtained by coating a surface of a metal plate with an insulating material, and the like can be exemplified. In addition, the board 21 may be formed of a single layer or multiple layers.

Further, the wiring pattern 21a is provided on a surface of the board 21. The wiring pattern 21a can be formed, for example, by a material containing silver as a main component. The wiring pattern 21a can be formed, for example, by silver or a silver alloy. However, the material of the wiring pattern 21a is not limited to the material containing silver as a main component. The wiring pattern 21a can also be formed, for example, by a material containing copper as a main component.

The light-emitting element 22 is provided at the side of the board 21 opposite to the bottom face 11a1 side of the concave part 11a. The light-emitting element 22 is provided on the board 21. The light-emitting element 22 is electrically connected to the wiring pattern 21a provided on the surface of the board 21. The light-emitting element 22 can be, for example, a light-emitting diode, an organic light-emitting diode, a laser diode, or the like. At least one light-emitting element 22 can be provided. If a plurality of light-emitting elements 22 are provided, the plurality of light-emitting elements 22 can be connected in series to each other. In addition, the light-emitting element 22 is connected in series to the resistor 23.

The light-emitting element 22 can be a chip-shape light-emitting element. The chip-shape light-emitting element 22 can be mounted by a chip on board (COB). In this manner, a large number of light-emitting elements 22 can be provided in a narrow region. Therefore, the light-emitting module 20 can be miniaturized, and further the vehicle luminaire 1 can be miniaturized. The chip-shape light-emitting element 22 can be, for example, an upper electrode type light-emitting element, a top-and-bottom electrode type light-emitting element, a flip chip type light-emitting element, or the like. The light-emitting element 22 illustrated in FIGS. 1 and 2 is a top-and-bottom electrode type light-emitting element. An electrode of the upper electrode type light-emitting element or an upper electrode of the top-and-bottom electrode type light-emitting element can be electrically connected to the wiring pattern 21a by a wiring 21b. The light-emitting element 22 and the wiring pattern 21a can be electrically connected, for example, by a wire bonding method. The flip chip type light-emitting element 22 can be mounted directly on the wiring pattern 21a.

The resistor 23 is provided at the side of the board 21 opposite to the bottom face 11a1 side of the concave part 11a. The resistor 23 is provided on the board 21. The resistor 23 is electrically connected to the wiring pattern 21a provided on the surface of the board 21. The resistor 23 can be, for example, a resistor such as a surface mount type resistor, a resistor having a lead wire (metal oxide film resistor), or a film type resistor formed by a screen printing method or the like. Note that the resistor 23 illustrated in FIG. 1 is a film type resistor.

A material for the film type resistor can be, for example, ruthenium oxide (RuO₂). The film type resistor can be formed, for example, by a screen printing method and a calcination method. If the resistor 23 is the film type resistor, it is possible to increase a contact area between the resistor 23 and the board 21. This makes it possible to improve heat-dissipation capability. In addition, a plurality of resistors 23 can be formed at once. Therefore, it is possible to improve productivity and suppress variation in resistance value in the plurality of resistors 23.

Here, since a forward voltage characteristic of the light-emitting element 22 varies, if an applied voltage between an anode terminal and a ground terminal is constant, variation occurs in brightness (light flux, luminance, luminous intensity, or illuminance) of light emitted from the light-emitting element 22. Therefore, a value of current flowing through the light-emitting element 22 is set within a predetermined range by the resistor 23 so that the brightness of the light emitted from the light-emitting element 22 falls within a predetermined range. In this case, the value of current flowing through the light-emitting element 22 falls within the predetermined range by changing a resistance value of the resistor 23.

If the resistor 23 is a surface mount type resistor, a resistor having a lead wire, or the like, the resistor 23 having an appropriate resistance value is selected depending on the forward voltage characteristic of the light-emitting element 22. If the resistor 23 is a film type resistor, when a part of the resistor 23 is removed, the resistance value can be increased. For example, a part of the resistor 23 can be easily removed by irradiating the resistor 23 with laser light. The number, sizes, arrangement, and the like of the resistors 23 are not limited to the examples, and can be changed as appropriate depending on the number, specification, and the like of the light-emitting elements 22.

The control element 24 is provided at the side of the board 21 opposite to the bottom face 11a1 side of the concave part 11a. The control element 24 is provided on the board 21. The control element 24 is electrically connected to the wiring pattern 21a provided on the surface of the board 21. The control element 24 is provided so that a reverse voltage is not applied to the light-emitting element 22 and pulse noise from a reverse direction is not applied to the light-emitting element 22.

The control element 24 can be, for example, a diode. The control element 24 can be, for example, a surface mount type diode, a diode having a lead wire, or the like. The control element 24 illustrated in FIG. 1 is a surface mount type diode.

In addition, a pull-down resistor can also be provided to detect disconnection of the light-emitting element 22 or to prevent the light-emitting element 22 from being wrongly turned on. Further, a coating part covering the wiring pattern 21a, the film type resistor, or the like can also be provided. The coating part can contain, for example, a glass material.

The frame 25 is provided at the side of the board 21 opposite to the bottom face 11a1 side of the concave part 11a. The frame 25 is provided on the board 21. The frame 25 is attached to the board 21. The frame 25 has a tube shape and has the light-emitting element 22 disposed inside. For example, the frame 25 surrounds the plurality of light-emitting elements 22. The frame 25 can be formed by a resin. The resin can be, for example, a thermoplastic resin such as polybutylene terephthalate (PBT), polycarbonate (PC), PET, nylon, polypropylene (PP), polyethylene (PE), or polystyrene (PS).

Further, particles of titanium oxide or the like are mixed with the resin so that the reflectance of light emitted from the light-emitting element 22 can be increased. Note that a mixed material is not limited to particles of titanium oxide, and may be particles of a material having a high reflectance of the light emitted from the light-emitting element 22. In addition, the frame 25 can also be formed, for example, by a white resin.

An inner wall surface of the frame 25 is a slope inclined in a direction away from a center axis of the frame 25 with increasing distance from the board 21. Therefore, some of the light emitted from the light-emitting element 22 is reflected at the inner wall surface of the frame 25 and is emitted toward the front side of the vehicle luminaire 1. That is, the frame 25 can have a function of defining a formation range of the sealing part 26 and a function of a reflector.

The sealing part 26 is provided inside the frame 25. The sealing part 26 is provided to cover the inside of the frame 25. That is, the sealing part 26 is provided inside the frame 25 and covers the light-emitting element 22, the wiring 21b, and the like. The sealing part 26 can be formed by a material with translucency. The sealing part 26 can be formed, for example, by filling the inside of the frame 25 with a resin. The filling with the resin can be performed, for example, using a liquid quantitative ejecting device such as a dispenser. A resin to be filled can be, for example, a silicone resin or the like.

Further, the sealing part 26 can include a phosphor. The phosphor can be, for example, an yttrium-aluminum-garnet-based (YAG-based) phosphor. However, the type of the phosphor can be changed as appropriate so that a predetermined emission color is obtainable depending on an application or the like of the vehicle luminaire 1.

The optical element 27 can be formed by a translucent material. The optical element 27 can be formed, for example, by a translucent resin such as a silicone resin, glass, or the like. The optical element 27 can be formed, for example, by a mold-forming method or the like.

The optical element 27 is provided on the sealing part 26 and at least a part of the circumferential edge of the optical element 27 is provided at an end face 25a of the frame 25 opposite to the board 21 side. The optical element 27 can be attached to at least any one of an end face 26a of the sealing part 26 and the end face 25a of the frame 25. The optical element 27, for example, diffuses and condenses the light emitted from the light-emitting element 22. The optical element 27 illustrated in FIGS. 1 and 2 is a convex lens. The optical element 27 as the convex lens condenses light so that predetermined light distribution characteristics are obtainable. Note that the optical element 27 is not limited to the convex lens, and may be, for example, a concave lens or the like. Herein, description will be made using the case of the optical element 27 being the convex lens as an example.

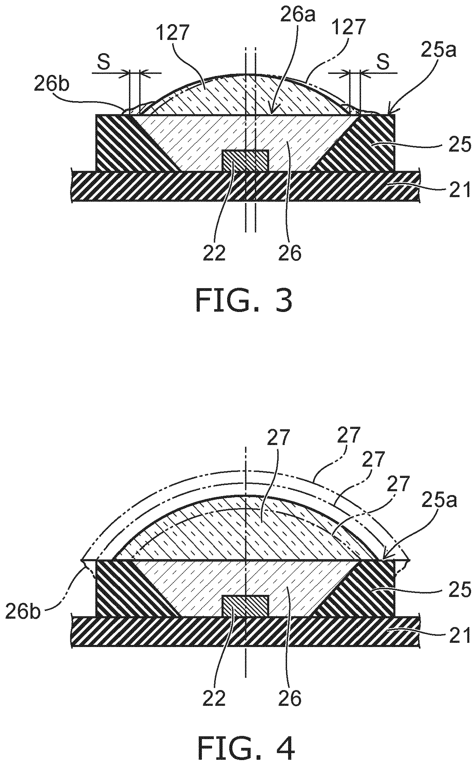

FIG. 3 is a schematic cross-sectional view for illustrating an optical element 127 according to a comparative example.

As illustrated in FIG. 3, the optical element 127 according to the comparative example is provided inside the frame 25 and on the end face 26a of the sealing part 26 opposite to the board 21 side.

In this case, positioning of the optical element 127 can be performed by fitting a circumferential edge of the optical element 127 to an opening of the frame 25. However, practically, since a production error occurs in dimensions of the frame 25 and the optical element 127, the fitting of the circumferential edge of the optical element 127 to the opening of the frame 25 is difficult. Therefore, as illustrated in FIG. 3, a gap S is provided between the circumferential edge of the optical element 127 and the opening of the frame 25.

However, if the gap S is provided, as illustrated in FIG. 3, the position of the optical element 127 may vary by the gap S. In addition, the position of the end face 26a of the sealing part 26 varies or the end face 26a is tilted so that the position of the optical element 127 may also vary. If the position of the optical element 127 varies, predetermined light distribution characteristics may not be obtainable. Further, an adhesive for attaching the optical element 127 and the sealing part 26 or a material 26b of the sealing part 26 before curing may leak through the gap S. If the adhesive or the material 26b of the sealing part 26 leaking through the gap S is attached to the circumferential edge or the like of the optical element 127, the shape of a light-emitting surface of the optical element 127 substantively changes. Thus, predetermined light distribution characteristics may not be obtainable.

FIG. 4 is a schematic cross-sectional view for illustrating the optical element 27 according to an exemplary embodiment.

As illustrated in FIG. 4, the optical element 27 is provided on the sealing part 26 and at least a part of the circumferential edge is provided at the end face 25a of the frame 25 opposite to the board 21 side. If the optical element 27 is provided at the end face 25a of the frame 25, inclination of the optical element 27 can be suppressed. In addition, positioning of the optical element 27 can be performed using the exterior wall or the like of the frame 25 as a reference. In this case, the optical element 27 can be attached to a predetermined position using a jig or the like. For example, a center axis of the optical element 27 can overlap the center axis of the frame 25.

As illustrated in FIG. 4, at least a part of the circumferential edge of the optical element 27 may be positioned at the outer side than the opening of the frame 25. For example, at least a part of the circumferential edge of the optical element 27 may be positioned on the inner wall of the frame 25 in planar view (when the light-emitting module 20 is viewed from above). In addition, at least a part of the circumferential edge of the optical element 27 may be positioned between the inner wall and the exterior wall of the frame 25 in planar view. Further, at least a part of the circumferential edge of the optical element 27 may be positioned at the outer side than the exterior wall of the frame 25 in planar view.

In this case, if the circumferential edge of the optical element 27 is positioned at the outer side than the inner wall of the frame 25, it is possible to stabilize the posture or position of the optical element 27 and to increase the contact area.

Herein, if the circumferential edge of the optical element 27 is positioned at the outer side than the inner wall of the frame 25, light directly entering the circumferential edge of the optical element 27 becomes least. Therefore, even if the protruding adhesive or the protruding material 26b is attached to the circumferential edge of the optical element 27, changing of the light distribution characteristics can be suppressed.

In this case, if the circumferential edge of the optical element 27 is positioned at the outer side than the exterior wall of the frame 25, the adhesive or the material 26b protruding outside the frame 25 is easy to flow to the board 21 side. Therefore, attachment of the adhesive or the material 26b to the circumferential edge of the optical element 27 can be suppressed.

With the optical element 27 according to the exemplary embodiment, it becomes easier to obtain predetermined light distribution characteristics.

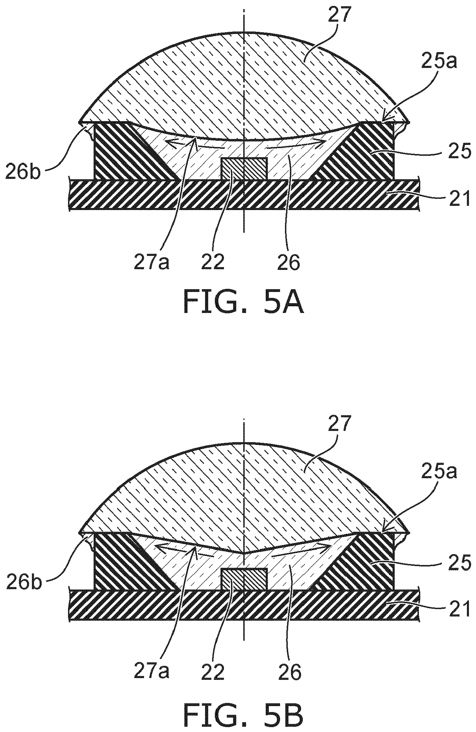

FIGS. 5A and 5B are schematic cross-sectional views for illustrating the optical element 27 according to another exemplary embodiment.

As illustrated in FIGS. 5A and 5B, a convex part 27a (corresponding to an example of the first convex part) projecting toward the sealing part 26 is provided in a center region on the surface of the optical element 27 at the board 21 side. The convex part 27a is provided inside the frame 25. A center axis of the convex part 27a can overlap the center axis of the optical element 27. The convex part 27a can be integrally formed with the optical element 27. The thickness of the convex part 27a gradually decreases toward the circumferential edge of the optical element 27. That is, the lateral surface of the convex part 27a is inclined. As illustrated in FIG. 5A, the shape of the convex part 27a can be a part of sphere, and as illustrated in FIG. 5B, the shape of the convex part 27a can be a circular cone. Note that the shape of the convex part 27a is not limited to the examples as long as the thickness gradually decreases toward the circumferential edge of the optical element 27. For example, the shape of the convex part 27a can also be a truncated cone, a pyramid, a truncated pyramid, or the like.

If the convex part 27a is provided, the material 26b of the sealing part 26 before curing is easy to eject outside the frame 25. Therefore, when the optical element 27 is pressed against the material 26b of the sealing part 26 before curing, air caught between the optical element 27 and the material 26b is easy to discharge. In addition, excessive pressure acting on the light-emitting element 22 or the wiring 21b can be suppressed.

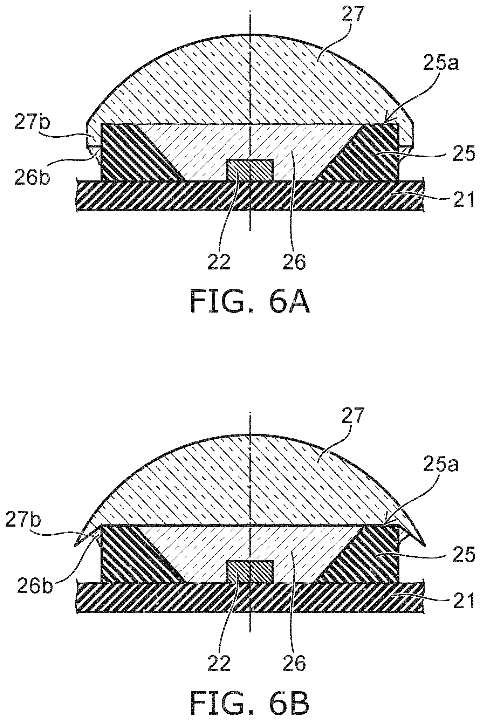

FIGS. 6A and 6B are schematic cross-sectional views for illustrating the optical element 27 according to another exemplary embodiment.

As illustrated in FIGS. 6A and 6B, a convex part 27b (corresponding to an example of the second convex part) projecting toward the board 21 is provided in a circumferential edge region of the surface of the optical element 27 at the board 21 side. The convex part 27b is provided outside the frame 25. The shape of the convex part 27b can be an annular shape. A center axis of the convex part 27b can overlap the center axis of the optical element 27. The convex part 27b can be integrally formed with the optical element 27. The inside dimension of the convex part 27b can be set to be slightly larger than the outside dimension of the frame 25. In this way, positioning of the optical element 27 with respect to the frame 25 becomes easier.

As illustrated in FIG. 6A, if the shape of the convex part 27b is a straight tube shape, positioning of the optical element 27 becomes easier.

As illustrated in FIG. 6B, if the inside dimension of the convex part 27b in a direction orthogonal to the center axis of the optical element 27 increases toward the circumferential edge of the optical element 27, the adhesive or the material 26b protruding outside the frame 25 is easy to flow to the board 21 side. Therefore, attachment of the adhesive or the material 26b to the circumferential edge of the optical element 27 can be suppressed.

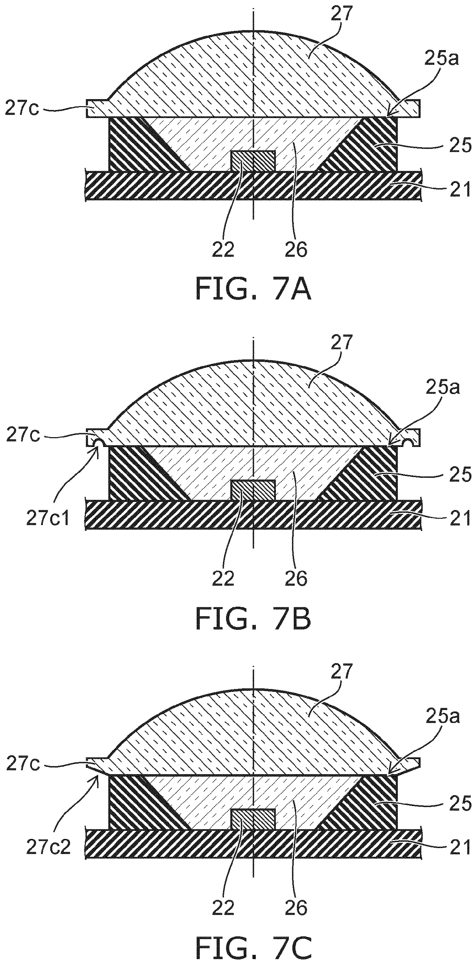

FIGS. 7A to 7C are schematic cross-sectional views for illustrating the optical element 27 according to another exemplary embodiment.

As illustrated in FIGS. 7A to 7C, a convex part 27c (corresponding to an example of the third convex part) projecting toward the direction orthogonal to the center axis of the optical element 27 can be provided at the circumferential edge of the optical element 27.

A center axis of the convex part 27c can overlap the center axis of the optical element 27. The convex part 27c can be integrally formed with the optical element 27. The shape of the convex part 27c can be an annular shape. If the convex part 27c is provided, the adhesive or the material 26b protruding outside the frame 25 is easy to flow to the board 21 side. Therefore, the posture of the optical element 27 can be stabilized.

As illustrated in FIG. 7B, a concave part 27c1 can be provided on a surface of the convex part 27c at the board 21 side. Note that the convex part may be provided on the surface of the convex part 27c at the board 21 side.

As illustrated in FIG. 7C, the surface of the convex part 27c at the board 21 side can be an inclined surface 27c2. Note that an inclined surface may be inclined in an opposite direction to that illustrated in FIG. 7C.

If the concave part 27c1, the convex part, or the inclined surface 27c2 is provided, the adhesive or the material 26b protruding outside the frame 25 coming around the circumferential edge of the optical element 27 can be suppressed.

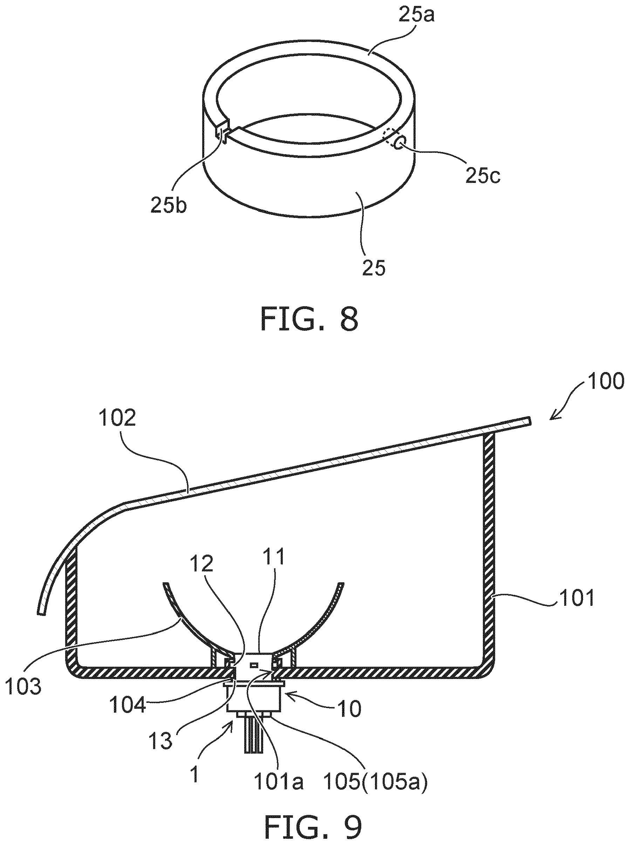

FIG. 8 is a schematic perspective view for illustrating the frame 25 according to another exemplary embodiment.

As illustrated in FIG. 8, a groove 25b can be provided at the end face 25a of the frame 25. The groove 25b opens to the end face 25a and penetrates between the inner wall and the exterior wall of the frame 25. It suffices to provide at least one groove 25b. If the groove 25b is provided, the excessive adhesive or the excessive material 26b can be discharged from the lower position than the end face 25a of the frame 25 to the outside of the frame 25. Therefore, attachment of the adhesive or the material 26b to the circumferential edge of the optical element 27 can be suppressed.

The number, sizes, shapes, arrangement, and the like of the grooves 25b are not limited to the examples, and can be changed as appropriate.

Further, a hole 25c penetrating between the inner wall and the exterior wall of the frame 25 can also be provided near the end face 25a. If the hole 25c is provided, the similar effect to that of the groove 25b can be attained.

The respective elements described above, for example, the convex part 27a, the convex part 27b, the convex part 27c, the concave part 27c1, the inclined surface 27c2, the groove 25b, the hole 25c, and the like can be combined as appropriate.

The example described above is an example in which the optical element 27 is molded in advance and the molded optical element 27 is bonded to at least any one of the sealing part 26 and the frame 25.

The optical element 27 can also be formed by supplying a resin onto the sealing part 26. For example, a resin having a thixotropic ratio (3 rpm/30 rpm) of 4 or more (for example, a silicone resin) can be supplied onto the sealing part 26 and a part of the supplied resin can be provided at the end face 25a. In this case, the shape of the supplied resin is a dome shape. In addition, the sealing part 26 and the optical element 27 can also be continuously formed and the optical element 27 can be formed after curing the material 26b of the sealing part 26. The supplying of the resin can be performed, for example, using a liquid quantitative ejecting device such as a dispenser.

The amount of dimensional change of the optical element 27 in a direction orthogonal to the light-emitting surface of the light-emitting element 22 (the amount of dimensional change of the optical element 27 in a thickness direction) is larger at the circumferential edge side of the optical element 27 than at the center side of the optical element 27. Therefore, the shape accuracy near the circumferential edge of the optical element 27 is prone to deteriorate. However, if the circumferential edge of the optical element 27 is provided at the end face 25a of the frame 25, primary light from the light-emitting element 22 being incident near the circumferential edge of the optical element 27 can be suppressed. Therefore, even if the shape accuracy near the circumferential edge of the optical element 27 slightly deteriorates, predetermined light distribution characteristics are obtainable.

If the optical element 27 is formed by supplying a resin, it is possible to significantly reduce a manufacturing cost.

However, if the molded optical element 27 is used, it becomes further easier to obtain predetermined light distribution characteristics.

### (Method for Manufacturing Vehicle Luminaire)

Next, a method for manufacturing a vehicle luminaire will be described.

The socket 10 is formed by an injection molding method, a die casting method, or the like.

The power-supply part 30 is formed by press-inserting the plurality of power-supply terminals 31 into holes of the insulating part 32 or integrally molding the plurality of power-supply terminals 31 and the insulating part 32 by an insert molding method.

Further, the light-emitting module 20 is formed.

First, the light-emitting element 22, the resistor 23, and the control element 24 are sequentially mounted on the board 21 having the wiring pattern 21a.

Subsequently, the light-emitting element 22 and the wiring pattern 21a are electrically connected by a wire bonding method.

Subsequently, the frame 25 is attached to the board 21 to surround the light-emitting element 22.

Subsequently, the sealing part 26 is formed by filling the inside of the frame 25 with a resin. The filling with the resin can be performed, for example, using a liquid quantitative ejecting device such as a dispenser.

Subsequently, the optical element 27 molded in advance is provided on the sealing part 26. The optical element 27 can be attached to at least any one of the end face 26a of the sealing part 26 and the end face 25a of the frame 25.

Further, the dome-shape optical element 27 can also be formed by supplying a resin having a thixotropic ratio (3 rpm/30 rpm) of 4 or more onto the sealing part 26. In this case, the sealing part 26 and the optical element 27 can also be continuously formed, and the optical element 27 can be formed after curing the material 26b of the sealing part 26. The supplying of the resin can be performed, for example, using a liquid quantitative ejecting device such as a dispenser.

Next, the power-supply part 30, the heat transfer part 40, and the light-emitting module 20 are sequentially assembled in the socket 10.

In this way, the vehicle luminaire 1 can be manufactured.

As described above, the method for manufacturing a vehicle luminaire according to an exemplary embodiment can include the following steps:
a step of providing at least one light-emitting element 22 and the frame 25 surrounding the light-emitting element 22 on the board 21;
a step of forming the sealing part 26 covering the light-emitting element 22 by filling the inside of the frame 25 with a resin; and
a step of forming the optical element 27 by supplying a resin onto the sealing part 26.

Further, in the step of forming the optical element, a resin having a thixotropic ratio (3 rpm/30 rpm) of 4 or more is supplied, and a part of the supplied resin is provided at the end face 25a of the frame 25 opposite to the board 21 side.

### (Vehicle Lamp)

Next, the vehicle lamp 100 will be illustrated.

Note that, in the following description, for example, description will be given using an example in which the vehicle lamp 100 is a front combination light provided in an automobile. However, the vehicle lamp 100 is not limited to the front combination light provided in the automobile. The vehicle lamp 100 may be a vehicle lamp provided in an automobile, a rail vehicle, or the like.

FIG. 9 is a schematic partial cross-sectional view for illustrating the vehicle lamp 100.

As illustrated in FIG. 9, the vehicle lamp 100 includes the vehicle luminaire 1, the housing 101, a cover 102, an optical element part 103, a sealing member 104, and the connector 105.

The vehicle luminaire 1 is attached to the housing 101. The housing 101 holds the mounting part 11. The housing 101 has a box shape in which one end side is opened. The housing 101 can be formed, for example, by a resin which does not transmit light, or the like. An attachment hole 101a is provided at the bottom face of the housing 101. A part of the mounting part 11 on which the bayonet 12 is provided is inserted into the attachment hole 101a. A concave part is provided at a circumferential edge of the attachment hole 101a. The bayonet 12 provided at the mounting part 11 is inserted into the concave part. Note that, although the example in which the attachment hole 101a is provided directly in the housing 101 is described, an attachment member having the attachment hole 101a may be provided in the housing 101.

When the vehicle luminaire 1 is attached to the vehicle lamp 100, the part of the mounting part 11 on which the bayonet 12 is provided is inserted into the attachment hole 101a and the vehicle luminaire 1 is rotated. In this way, the bayonet 12 is held at the concave part provided at the circumferential edge of the attachment hole 101a. Such an attachment method is called twist lock.

The cover 102 is provided to cover the opening of the housing 101. The cover 102 can be formed by a resin with translucency, or the like. The cover 102 can also have a function of a lens or the like.

Light emitted from the vehicle luminaire 1 enters the optical element part 103. The optical element part 103, for example, reflects, diffuses, guides, and condenses the light emitted from the vehicle luminaire 1, and forms a predetermined light distribution pattern.

For example, the optical element part 103 illustrated in FIG. 9 is a reflector. In this case, the optical element part 103 reflects the light emitted from the vehicle luminaire 1 to form a predetermined light distribution pattern.

The sealing member 104 is provided between the flange 13 and the housing 101. The sealing member 104 can be formed in an annular shape. The sealing member 104 can be formed by a material with elasticity such as rubber or a silicone resin.

When the vehicle luminaire 1 is attached to the vehicle lamp 100, the sealing member 104 is sandwiched between the flange 13 and the housing 101. Therefore, an internal space of the housing 101 is sealed by the sealing member 104. In addition, the bayonet 12 is pressed against the housing 101 by elastomeric force of the sealing member 104. Therefore, detachment of the vehicle luminaire 1 from the housing 101 can be suppressed.

The connector 105 is fitted to ends of the plurality of power-supply terminals 31 exposed to the inside of the hole 10b. A power-supply or the like (not illustrated) is electrically connected to the connector 105. Therefore, by fitting the connector 105 to the ends of the plurality of power-supply terminals 31, the power-supply or the like (not illustrated) is electrically connected to the light-emitting element 22.

Further, the connector 105 has a step portion. Then, the sealing member 105a is attached to the step portion. The sealing member 105a is provided to prevent water from infiltrating to the inside of the hole 10b. When the connector 105 having the sealing member 105a is inserted into the hole 10b, the hole 10b is watertightly sealed.

The sealing member 105a can be formed in an annular shape. The sealing member 105a can be formed by a material with elasticity such as rubber or a silicone resin. The connector 105 can also be bonded to an element at the socket 10 side, for example, using an adhesive or the like.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions. Moreover, above-mentioned embodiments can be combined mutually and can be carried out.

## Claims

1. A vehicle luminaire (1) comprising:
a socket (10);
a board (21) provided at one end side of the socket (10);
at least one light-emitting element (22) provided on the board (21);
a frame (25) provided on the board (21), having a tube shape, and surrounding the light-emitting element (22);
a sealing part (26) provided inside the frame (25) and covering the light-emitting element (22); and
an optical element (27) provided on the sealing part (26), at least a part of a circumferential edge being provided at an end face (25a) of the frame (25) opposite to the board (21) side.

2. The luminaire (1) according to claim 1, wherein at least a part of the circumferential edge of the optical element (27) is positioned on an inner wall of the frame (25) in planar view.

3. The luminaire (1) according to claim 1, wherein at least a part of the circumferential edge of the optical element (27) is positioned between an inner wall and an exterior wall of the frame (25) in planar view.

4. The luminaire (1) according to claim 1, wherein at least a part of the circumferential edge of the optical element (27) is positioned at the outer side than an exterior wall of the frame (25) in planar view.

5. The luminaire (1) according to any one of claims 1 to 4, wherein a first convex part (27a) projecting toward the sealing part (26) is provided in a center region on a surface of the optical element (27) at the board (21) side.

6. The luminaire (1) according to any one of claims 1, 4, and 5, wherein a second convex part (27b) projecting toward the board (21) is provided in a circumferential edge region on a surface of the optical element (27) at the board (21) side.

7. The luminaire (1) according to any one of claims 1 to 6, further comprising a third convex part (27c) provided at a circumferential edge of the optical element (27) and projecting in a direction orthogonal to a center axis of the optical element (27).

8. The luminaire (1) according to any one of claims 1 to 7, wherein the frame (25) comprises at least any one of
a groove (25b) opened to an end face (25a) opposite to the board (21) side and penetrating between an inner wall and an exterior wall of the frame (25), and
a hole (25c) provided near the end face (25a) and penetrating between the inner wall and the exterior wall of the frame (25).

9. A vehicle lamp (100) comprising:
the vehicle luminaire (1) according to any one of claims 1 to 8; and
a housing (101) to which the vehicle luminaire is attached.

10. A method for manufacturing a vehicle luminaire, comprising:
providing at least one light-emitting element (22) and a frame (25) surrounding the light-emitting element (22) on a board (21);
forming a sealing part (26) covering the light-emitting element (22) by filling the inside of the frame (25) with a resin; and
forming an optical element (27) by supplying a resin onto the sealing part (26),
in the forming of the optical element (27),
a resin having a thixotropic ratio (3 rpm/30 rpm) of 4 or more being supplied, and
a part of the supplied resin being provided at an end face (25a) of the frame (25) opposite to the board (21) side.
